# EUROPEAN PATENT SPECIFICATION

(11) **EP 1 228 676 B1**
(45) Date of publication and mention of the grant of the patent: **16.06.2004**
(21) Application number: 00990505.0
(22) Date of filing: 08.11.2000
(51) Int. Cl.: H05K 13/00, H05K 13/04

(54) **METHOD AND APPARATUS FOR HOLDING A PRINTED CIRCUIT BOARD IN A PRECISE POSITION DURING PROCESSING**
VERFAHREN UND VORRICHTUNG ZUR HALTUNG EINER LEITERPLATTE IN EINER GENAUEN POSITION WÄHREND DER VERARBEITUNG
PROCEDE ET DISPOSITIF POUR MAINTENIR UNE CARTE DE CIRCUITS IMPRIMES DANS UNE POSITION PRECISE PENDANT LE TRAITEMENT

(30) Priority: 08.11.1999 US 163934 P
(43) Date of publication of application: 07.08.2002
(73) Proprietor: Speedline Technologies, Inc., Franklin, MA 02038 (US)
(72) Inventor: ASHTON, Augustus, T., Westboro, MA 01581 (US); WILLSHERE, Richard, Preston, Weymouth DT3 (GB)
(74) Representative: Draper, Martyn John
(86) International application number: PCT/US2000/042009
(87) International publication number: WO 2001/035708

(56) References cited:
- EP-A- 0 606 928
- US-A- 4 951 240
- US-A- 5 722 527

## Description

### FIELD OF THE INVENTION

This invention relates to a method and apparatus for holding a printed circuit board and; more particularly, to a method and apparatus for holding a printed circuit board while the board is subjected to a solder paste printing process.

### BACKGROUND OF THE INVENTION

The present invention relates to printed circuit board manufacture and; more particularly, to solder paste printers.

Solder paste printers are typically employed to form solder paste patterns on printed circuit boards for subsequently mounted electrical components. Generally, solder paste printers include a conventional conveyor system for transporting a printed circuit board through a number of processing stations, including a print station. The conveyor system typically includes a pair of elongated longitudinal rails oriented parallel with respect to each other. The rails each have a number of pulleys mounted thereon, and at least one of the pulleys is motorized. Each of the rails further includes a drive belt mounted on the pulleys, whereby movement of the pulleys causes a printed circuit board positioned on the conveyor to move along the conveyor.

One processing station includes the operation of positioning a stencil, which stencil has a planar surface with a number of apertures defined thereon, onto the printed circuit board. Solder paste is thereafter uniformly distributed, in a manner well known in the art, over the planar surface with a squeegee, so that solder is deposited at designated sites on the board. Specifically, a controlled downwardly directed force is exerted on the solder paste by the squeegee so that the solder paste is forced through the number of apertures defined on the stencil and onto the printed circuit board for forming the solder paste patterns thereon. Another processing station can include a mechanical arm assembly that picks and places electrical components onto the printed circuit board.

It is important to hold the circuit board substantially flat as well as in a predetermined orientation during printed circuit board processing operations which are conducted at each processing station. Positioning and holding the printed circuit board substantially flat as well as in the predetermined orientation can be difficult because the circuit board substrate is comprised of a relatively thin and flexible material. The downwardly directed forces exerted on the printed circuit board by the squeegee can cause the board to bend or flex while the solder paste patterns are deposited thereon. The resulting solder paste patterns formed on the printed circuit may not register with the designated sites on the circuit board. The problem is further compounded when electrical components subsequently positioned do not electrically connect with the designated sites, resulting in printed circuit board failure.

It is important that the printed circuit board not move from the predetermined orientation while depositing the solder paste patterns on the board with the squeegee. This can occur as a result of the printed circuit board being supported on drive belts constructed of an elastic material such as rubber. If the printed circuit board moves from the predetermined orientation during the solder paste printing process, the solder paste patterns formed on the printed circuit board may be misaligned.

A prior mechanism for holding a printed circuit board in position is shown and described in U.S. Patent No. 5, 157, 438 to Beale (hereinafter "Beale"). In Beale, the mechanism for holding the printed circuit board in position for solder paste printing includes supporting the circuit board with a plurality of elongated members ( or support rods) that cooperate with a platform and a number of pneumatic cylinders to actuate the support rods. Beale further includes a mechanism that clamps the edges of the circuit board to the elastic drive belts of the conveyor for minimizing vertical movement of said board. One drawback in Beale is that the clamping mechanism clamps the edges of the printed circuit board to the elastic drive belts, which belts themselves can move as previously mentioned. In addition, another drawback is that the edge clamping mechanism in Beale incorporates clamping foils positioned on each side of the printed circuit board that require actuating devices and controls for such actuating devices. The actuating devices and controls add to the expense and complexity of the clamping functions.

A further prior mechanism is described in US 5,722,527. This document discloses a complex arrangement of upper and lower clamping surfaces and actuators, which impose a couple on two opposing edges of a circuit. board, to produce a bending moment in the circuit board and force it into contact with one or more support pins.

With the increased number of electrical components that are affixed to printed circuit boards, there are increased requirements for precision tolerances in solder paste patterns. Accordingly, a need exists for a printed circuit board holding mechanism that holds the printed circuit board in a precise position during solder paste printing operations and which overcomes limitations and deficiencies of the prior art.

One object of the present invention is to provide an improved printed circuit board holding mechanism.

Accordingly a first aspect of the present invention provides an apparatus for supporting a circuit board, comprising a horizontally disposed conveyor for transporting the circuit board to a processing station, a pair of clamp rails including first and second rails mounted on opposite sides of the conveyor, at the processing station, the clamp rails being resiliently biased vertically downward to releasably engage the circuit board in the processing station and at least one moveable tooling pin positioned on a pin support table located below the conveyor at the processing station, the support table being movable in an upward vertical direction, where upon upward vertical movement of the support table, the at least one tooling pin contacts a bottom surface of the circuit board at the processing station for lifting the circuit board off of the conveyor and ensures contact of a top edge portion of the circuit board against the clamp rails.

### BRIEF DESCRIPTION OF THE DRAWINGS

The foregoing and other objects of this invention, the various features thereof, as well as the invention itself, can be more fully understood from the following description when read together with the accompanying drawings in which:
Fig. 1 is a partial top plan view of a solder paste printer conveyor system having principles of the present invention;
Fig. 2 is a partial side view of the slotted board support strip mounted on the conveyor system shown in Fig. 1;
Fig. 3 is a partial cross-sectional view of the printed circuit board holding mechanism; and
Fig. 4 is partial cross-sectional view of the printed circuit board holding mechanism of Fig. 1 shown in an engaged relationship with a printed circuit board.

### DETAILED DESCRIPTION OF THE PREFERRED EMBODIMENTS

The present invention provides an improved printed circuit board holding mechanism for use in conjunction with a solder paste printing apparatus.

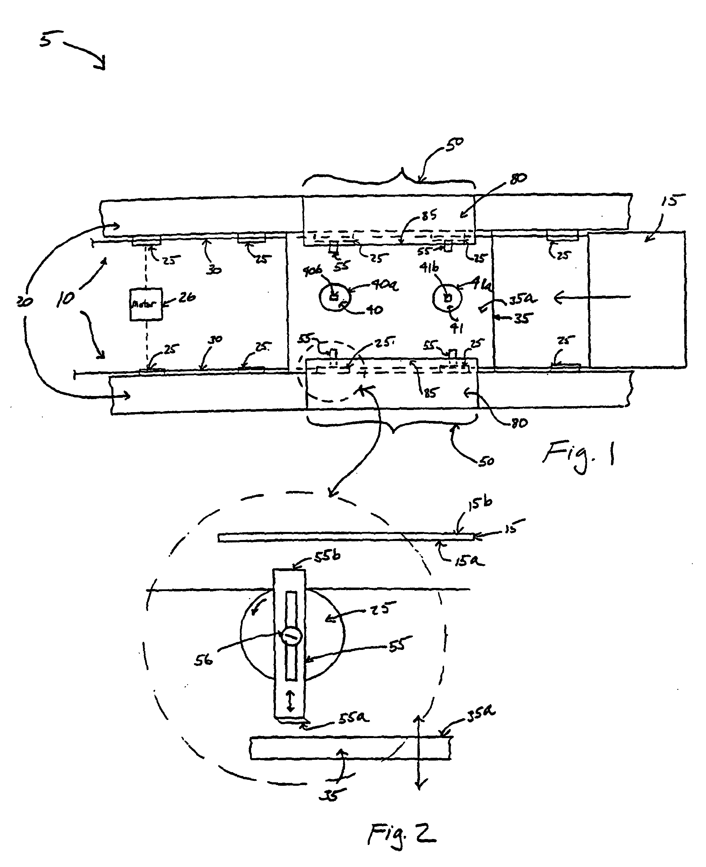

In one embodiment of the present invention shown in Figs. 1 and 2, solder paste printing apparatus 5 generally includes conveyor system 10 for transporting printed circuit board 15 through a number of processing stations. Conveyor system 10 typically includes a pair of elongated longitudinal conveyor rails 20 oriented parallel with respect to each other. Conveyor rails 20 each have a number of pulleys 25 mounted thereon, whereby at least one of the pulleys 25 is motorized by, for example, one or more electric motors 26. Drive belt 30 is mounted on the pulleys 25 associated with each rail 20 so that when rotational motion is transposed to the pulleys 25 by the motor, drive belts 30 move linearly.

Solder paste printing apparatus 5 further includes a movable printed circuit board pin support table 35 having one or more tooling pins 40 and 41 mounted thereon. Pin support table 35 can be actuated, for example, by a hydraulic or pneumatic cylinder (not shown) to vertically move towards and/or away from printed circuit board 15. Pin support table 35 can be constructed from a rigid and sturdy material such as steel or a metal alloy. Tooling pins 40 and 41, which are mounted on pin support table 35, may be in the form of a cylinder having one end 40a and 41a respectively mounted on the pin support table 35 and another end 40b and 41 b respectively adapted to intermittently contact bottom surface 15a of printed circuit board 15.

A number of slotted board support strips 55 are slidably attached to each of the conveyor rails 20. Each slotted board support strip 55 can slide vertically upward and/or downward with respect to a mounting screw 56 associated with slotted board support strip 55. Each board support strip 55 includes a first end 55a adapted to intermittently contact pin support table 35 and a second end 55b adapted to intermittently contact bottom surface 15a of printed circuit board 15. While in Fig. 1 the slotted board support strip 55 is shown as being narrow in its dimension perpendicular to the slot, and four such strips are shown, it is to be understood that narrow dimension may be lengthened to, for example, up to the dimension of table 35 to provide support along the entire bottom of board 15. Also, while slotted board support strip 55 and screw 56 mount are illustrated herein, it is understood that other mechanisms may be utilized to move upward and/or downward with table 35 and provide support to bottom surface 15a of printed circuit board 15. For example, slotted board support strips 55 may not be mounted on conveyor rails 20 at all, but rather mounted directly on pin support table 35.

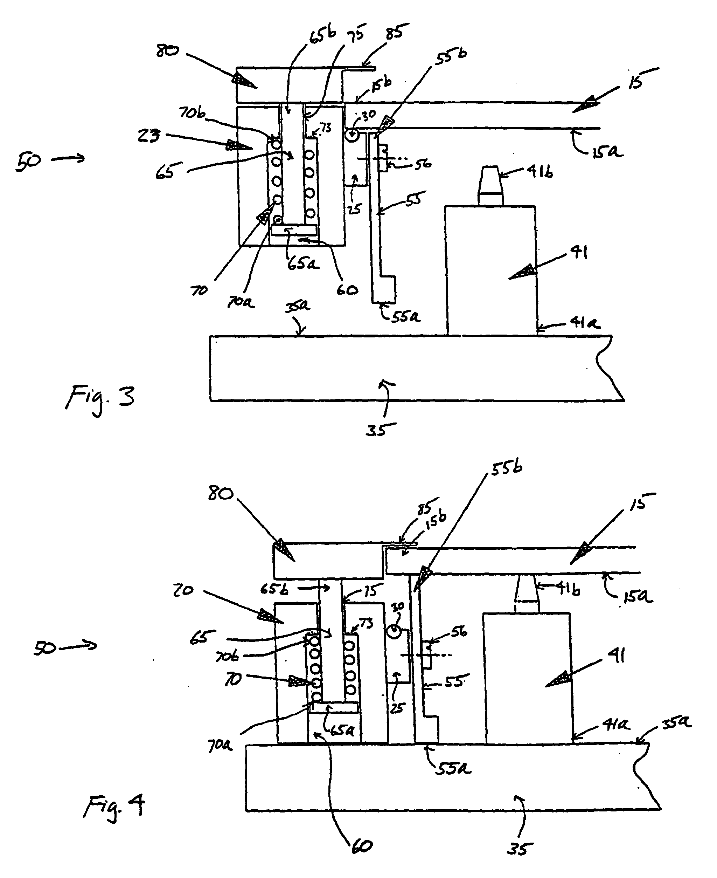

Referring to Figs. 1 and 3, at least one segment 50 of each conveyor rail 20 includes a clamp rail support 23 having hollow interior cavity 60 dimensioned to accept a piston 65 having a first end 65a and a second end 65b. First end 65a of piston 65 is dimensioned to conformingly contact first end 70a of helical compression spring 70 which is also positioned in cavity 60. Second end 70b of compression spring 70 conformingly contacts an annular collet 73 formed on an interior portion of cavity 60. When first end 65a of piston 65 is moved upwardly, spring 70 is compressed which forces a second end 65b of piston 65 to extend outwardly from aperture 75 formed on a wall of cavity 60. Clamp rail 80 is coupled to second end 65b of piston 65. Clamp rail 80 includes clamping foil 85 which may be integrally formed on clamp rail 80. Each clamping foil 85 is oriented to extend inwardly so each clamp foils 85 mounted on opposing rails 20 face each other and are dimensioned to overlap opposite top edges 15b of printed circuit board 15. It is to be understood that clamping foil 85 may be separate from clamp rail 80 and joined to clamp rail 80 by adhesives, screws or other conventional attachment devices. Also, it is to be understood that clamp rail 80 with its clamping foil 85 may extend along the entire length of clamp rail 80 or only in segment 50 or even less than the length of segment 50, as desired to hold down printed circuit board 15.

During operation and as shown in Fig. 4, pin support table 35 moves upwardly until one end 41 b of tooling pin 41 contacts bottom surface 15a of printed circuit board 15. After tooling pin 41 contacts bottom surface 15a of printed circuit board 15, pin support table 35 continues moving upwardly and lifts printed circuit board 15 off conveyor system 10. Printed circuit board 15 continues to move upwardly until top edge 15b of printed circuit board 15 contacts each of foils 85 defined on clamping rails 80. Upon contacting foils 85 of clamping rails 80 with printed circuit board 15, clamping rails 80 and foils 85 move upwardly, however, clamping rails 80 and foils 85 are spring biased downwardly. Upward movement of clamping rails 80 and foils 85 is limited by the distance that compression spring 70 can travel. Compression of compression spring 70 generates a downwardly directed pre-load force on clamping foil 85 which is transposed to top edge 15b of printed circuit board 15 to securely hold printed circuit board 15 in a sandwiched position between foils 85, second ends 55b of board support strips 55 and one end 41b of tooling pin 41.

Also, during the same movement in which the pin support table 35 moves upwardly, the pin support table contacts first ends 55a of slotted board support strips 55. After initial contact, and as pin support table 35 continues its upward movement, slotted board support strips 55 slide upwardly along mounting screw 56 until second ends 55b of slotted board support strips 55 contact bottom surface 15a of printed circuit board 15 and lifts the printed circuit board 15 off drive belt 30. At the upper limit of movement of pin support table 35, printed circuit board 35 is securely held in a suspended position off conveyon system 10 (Fig.4). Printed circuit board 15 is supported on bottom surface 15a by slotted board support strips 55 and tooling pin 41 and top edges 15b of printed circuit board 15 are held by clamping rails 80 and associated foils 85. In this orientation, printed circuit board 15 is securely held so that motion of printed circuit board 15 during processing is significantly reduced or eliminated. As shown in Fig. 4, the height of slotted board support strip 55 and tooling pin 41 are preferably equal so that substantially the same support is provided to bottom surface 15a of printed circuit board 15. Also, while tooling pin 41 is shown as having a substantially conical portion 41b, it is to be understood that tooling 41 may be of any desired shape or dimension and used in a suitable number across upper surface 35a of pin support table 35 to provide support for an interior region of bottom surface 15a of printed circuit board 15.

## Claims

1. An apparatus for supporting a circuit board (15), comprising:
a horizontally disposed conveyor (10) for transporting the circuit board (15) to a processing station;
a pair of clamp rails (80) including first and second rails mounted on opposite sides of the conveyor (10), at the processing station, the clamp rails (80) being resiliently biased vertically downward to releasably engage the circuit board (15) in the processing station; and
at least one support member pin (40,41) positioned on a pin support table (35) located below the conveyor (10) at the processing station, the support table (35) being movable in an upward vertical direction, where upon upward vertical movement of the support table (35), the at least one support member (40, 41) contacts a bottom surface (15a) of the circuit board (15) at the processing station for lifting the circuit board (15) off of the conveyor (10) and ensures contact of a top edge portion (15b) of the circuit board (15) against the clamp rails (80).

2. The apparatus for supporting a circuit board (15) of claim 1, wherein the support member (40, 41) is a cylinder having one end (40a, 41a) adapted for mounting on the pin support table (35) and another end (40b, 41b) adapted to contact the bottom surface (15a) of the circuit board (15).

3. The apparatus for supporting a circuit board (15) of claim 1, further including a plurality of vertically disposed elongated board support strips (55) mounted on the conveyor (10) for vertical upward and downward movement with respect to the conveyor (10).

4. The apparatus for supporting a circuit board (15) of claim 3, wherein each support strip (55) includes a first end (55a) adapted to contact the pin support table (35) and a second end (55b) adapted to contact the bottom surface (15a) of the circuit board (15) when the pin support table (35) moves in an upward direction, the strips (55) supporting bottom edges of the circuit board (15) against the pair of clamp rails (80).

5. The apparatus for supporting a circuit board (15) of claim 4, wherein each elongated strip (55) includes an elongated slot, a pin positioned in the slot and fixed to the conveyor (10) travels within the slot such that movement of the elongated strip (55) is limited by the length of the elongated slot.

6. The apparatus for supporting a circuit board (15) of claim 1, wherein each clamp rail (80) includes a clamping foil (85) which engages the top edge portion (15b) of the circuit board 15.

7. The apparatus for supporting a circuit board (15) of claim 1, wherein the conveyor (10) includes:
a pair of elongated longitudinal, conveyor rails (20) oriented parallel to but spaced from each other;
a plurality of pulleys (25) mounted on each conveyor rail (20);
a motor (26) coupled to at least one pulley (25) of the plurality of pulleys (25);
a drive belt (30) mounted on the pulleys (25) on each conveyor rail (20), such that upon rotational motion of the pulleys (25) by the motor (26), the drive belts(30) move in a linear direction.

8. The apparatus for supporting a circuit board (15) of claim 1, further comprising a clamp rail support (23) at the processing station, the clamp rail support (23) having a hollow interior cavity (60) dimensioned to accept a piston (65), the piston (65) having a first end (65a) and a second end (65b), the first end (65a) being dimensioned to contact a first end (70a) of a helical spring (70) positioned in the cavity (60) and the second end (65b) of the piston (65) being coupled to the clamp rail (80), a second end (70b) of the spring (70) being seated in an annular collet (73) formed on an interior portion of the cavity (60), wherein if the first end (65a) of piston (65) is moved upwardly, the spring (70) is compressed to enable the second end (65a) of the piston (65) to extend outwardly from an aperture (75) formed on a wall of the cavity (60) to move the clamp rail (80) upwardly.

9. A method of processing a circuit board (15), comprising the steps of:
(i) positioning the circuit board (15) on a substantially horizontal conveyor (10) and moving the circuit board (15) to a processing station;
(ii) moving a horizontally disposed pin support table (35) located below the conveyor (10) at the processing station upwardly such that a support member (40, 41) mounted on the pin support table (35) contacts a bottom surface (15a) of the circuit board (15) to lift the circuit board (15) upwardly off of the conveyor (10);
(iii) moving the circuit board (15) upwardly until opposite top edge portions (15b) of the circuit board (15) contact foils (85) defined on a pair of downwardly resiliently biased clamping rails (80), the foils (85) and the support member (40, 41) supporting the circuit board (15); and
(iv) processing the circuit board (15).

## Patentansprüche

1. Vorrichtung zum Abstützen einer SchaltungsSchaltungsplatine (15), umfassend:
eine horizontal angeordnete Fördervorrichtung (10) zum Transportieren der Schaltungsplatine (15) zu einer Verarbeitungsstation;
ein Paar von Klemmschienen (80), umfassend eine erste und eine zweite Schiene, welche an gegenüberliegenden Seiten der Fördervorrichtung (10) montiert sind, an der Verarbeitungsstation, wobei die Klemmschienen (80) in vertikaler Richtung nach unten elastisch vorgespannt sind, um die Schaltungsplatine (15) in der Verarbeitungsstation lösbar in Eingriff zu nehmen; sowie
wenigstens einen Abstützelementstift (40, 41), welcher an einem unter der Fördervorrichtung (10) bei der Verarbeitungsstation gelegenen Stiftabstütztisch (35) positioniert ist, wobei der Abstütztisch (35) in einer vertikalen Richtung nach oben bewegbar ist, wobei bei einer vertikalen Aufwärtsbewegung des Abstütztisches (35) das wenigstens eine Abstützelement (40, 41) eine Bodenfläche (15a) der Schaltungsplatine (15) an der Bearbeitungsstation kontaktiert, um die Schaltungsplatine (15) von der Fördervorrichtung (10) abzuheben, und einen Kontakt eines oberen Randabschnitts (15b) der Schaltungsplatine (15) gegen die Klemmschienen (80) sicherstellt.

2. Vorrichtung zum Abstützen einer Schaltungsplatine (15) nach Anspruch 1, wobei das Abstützelement (40, 41) ein Zylinder ist mit einem Ende (40a, 41 a), welches zum Anbringen an dem Stiftabstütztisch (35) ausgebildet ist, und mit einem weiteren Ende (40b, 41 b), welches dazu ausgebildet ist, die untere Fläche (15a) der Schaltungsplatine (15) zu kontaktieren.

3. Vorrichtung zum Abstützen einer Schaltungsplatine (15) nach Anspruch 1, ferner umfassend eine Mehrzahl von in vertikaler Richtung angeordneten länglichen Platinenabstützstreifen (55), welche an die Fördervorrichtung (10) für eine vertikale Bewegung nach oben und nach unten bezüglich der Fördervorrichtung (10) montiert sind.

4. Vorrichtung zum Abstützen einer Schaltungsplatine (15) nach Anspruch 3, wobei jeder Abstützstreifen (55) ein erstes Ende (55a) aufweist, welches dazu ausgebildet ist, den Stiftabstütztisch (35) zu kontaktieren, sowie ein zweites Ende (55b) aufweist, welches dazu ausgebildet ist, die untere Fläche (15a) der Schaltungsplatine (15) dann zu kontaktieren, wenn der Stiftabstütztisch (35) sich in eine Richtung nach oben bewegt, wobei die Streifen (55) untere Ränder der Schaltungsplatine (15) gegen das Paar von Klemmschienen (80) abstützen.

5. Vorrichtung zum Abstützen einer Schaltungsplatine (15) nach Anspruch 4, bei welcher jeder längliche Streifen (55) einen länglichen Schlitz umfasst, wobei ein in dem Schlitz angeordneter und an der Fördervorrichtung (10) befestigter Stift sich innerhalb des Schlitzes derart bewegt, dass eine Bewegung des länglichen Streifens (55) durch die Länge des länglichen Schlitzes begrenzt ist.

6. Vorrichtung zum Abstützen einer Schaltungsplatine (15) nach Anspruch 1, bei welcher jede Klemmschiene (80) eine Klemmfolie (85) umfasst, welche den oberen Randabschnitt (15b) der Schaltungsplatine (15) in Eingriff nimmt.

7. Vorrichtung zum Abstützen einer Schaltungsplatine (15) nach Anspruch 1, bei welcher die Fördervorrichtung (10) umfasst:
ein Paar von länglichen Längsförderschienen (20), welche parallel orientiert, jedoch mit Abstand voneinander angeordnet sind;
eine Mehrzahl von Scheiben (25), welche an jede Förderschiene (20) montiert sind;
einen Motor (26), welcher mit wenigstens einer Scheibe (25) aus der Mehrzahl von Scheiben (25) gekoppelt ist;
einen Antriebsriemen (30), welcher an die Scheiben (25) einer jeden Förderschiene (20) derart montiert ist, dass bei einer Drehbewegung der Scheiben (25) durch den Motor (26) die Antriebsriemen (30) sich in einer linearen Richtung bewegen.

8. Vorrichtung zum Abstützen einer Schaltungsplatine (15) nach Anspruch 1, ferner umfassend eine Klemmschienenabstützung (23) an der Verarbeitungsstation, wobei die Klemmschienenabstützung (23) eine hohle Innenkavität (60) aufweist, welche derart bemessen ist, dass sie einen Kolben (65) aufnimmt, wobei der Kolben (65) ein erstes Ende (65a) und ein zweites Ende (65b) aufweist, wobei das erste Ende (65a) derart bemessen ist, dass es ein erstes Ende (70a) einer Schraubenfeder (70) kontaktiert, die in der Kavität (60) angeordnet ist, und wobei das zweite Ende (65b) des Kolbens (65) mit der Klemmschiene (80) gekoppelt ist, wobei ein zweites Ende (70b) der Feder (70) in einer ringförmigen Hülse (73) ruht, welche an einem Innenabschnitt der Kavität (60) ausgebildet ist, wobei dann, wenn das erste Ende (65a) des Kolbens (65) nach oben bewegt wird, die Feder (70) zusammengedrückt wird, um das zweite Ende (65a) des Kolbens (65) in die Lage zu versetzen, von einer Öffnung (75) aus, welche an einer Wandung der Kavität (60) ausgebildet ist, nach außen zu verlaufen, um die Klemmschiene (80) nach oben zu bewegen.

9. Verfahren einer Verarbeitung einer Schaltungsplatine (15), welches die folgenden Schritte umfasst:
(i) Positionieren der Schaltungsplatine (15) auf einer im Wesentlichen horizontalen Fördervorrichtung (10) und Bewegen der Schaltungsplatine (15) zu einer Verarbeitungsstation;
(ii) Bewegen eines horizontal angeordneten Stiftabstütztisches (35), welcher an der Verarbeitungsstation unterhalb der Fördervorrichtung (10) gelegen ist, derart nach oben, dass ein Abstützelement (40, 41), welches an den Stiftabstütztisch (35) montiert ist, eine untere Fläche (15a) der Schaltungsplatine (15) kontaktiert, um die Schaltungsplatine (15) von der Fördervorrichtung (10) nach oben abzuheben;
(iii) Bewegen der Schaltungsplatine (15) nach oben, bis entgegengesetzte obere Randabschnitte (15b) der Schaltungsplatine (15) Folien (85) kontaktieren, welche auf einem Paar von elastisch nach unten vorgespannten Klemmschienen (80) definiert sind, wobei die Folien (85) und das Abstützelement (40, 41) die Schaltungsplatine (15) abstützen; sowie
(iv) Verarbeiten der Schaltungsplatine (15).

## Revendications

1. Appareil de support d'une carte à circuits imprimés (15) comprenant :
un convoyeur (10) disposé horizontalement pour transporter la carte à circuits imprimés (15) vers une station de traitement ;
une paire de rails de serrage (80) comprenant des premier et second rails, montés sur des côtés opposés du convoyeur (10) au niveau de la station de traitement, les rails de serrage (80) étant précontraints élastiquement, verticalement vers le bas, afin d'engager de manière amovible la carte à circuits imprimés (15) dans la station de traitement ; et
au moins un élément d'appui (40, 41) positionné sur une table d'appui (35) située au-dessous du convoyeur (10) au niveau de la station de traitement, la table d'appui (35) pouvant se déplacer verticalement vers le haut si bien qu'après le mouvement vertical vers le haut de la table d'appui (35), l'au moins un élément d'appui (40, 41), entre en contact avec une surface inférieure (15a) de la carte à circuits imprimés (15) au niveau de la station de traitement, afin de soulever la carte à circuits imprimés (15) du convoyeur (10) et assurer le contact entre une partie marginale supérieure (15b) de la carte à circuits imprimés (15) et les rails de serrage (80).

2. Appareil de support d'une carte à circuits imprimés (15) selon la revendication 1, dans lequel l'élément d'appui (40, 41) est un cylindre ayant une extrémité (40a, 41a) conçue pour le montage sur la table d'appui (35) et une autre extrémité (40b, 41b) conçue pour entrer en contact avec la surface inférieure (15a) de la carte à circuits imprimés (15).

3. Appareil de support d'une carte à circuits imprimés (15) selon la revendication 1, comprenant en outre une pluralité de jambes allongées d'appui de carte (55) disposées verticalement, montées sur le convoyeur (10) afin de décrire un mouvement vertical, vers le haut et vers le bas, par rapport au convoyeur (10).

4. Appareil de support d'une carte à circuits imprimés (15) selon la revendication 3, dans lequel chacune de ces jambes d'appui (55) comprend une première extrémité (55a) conçue pour entrer en contact avec la table d'appui (35) et une seconde extrémité (55b) conçue pour entrer en contact avec la surface inférieure (15a) de la carte à circuits imprimés (15) lorsque la table d'appui (35) se déplace vers le haut, les jambes (55) supportant les bords inférieurs de la carte à circuits imprimés (15) en les poussant contre la paire de rails de serrage (80).

5. Appareil de support d'une carte à circuits imprimés (15) selon la revendication 4, dans lequel chacune de ces jambes allongées (55) comprend une encoche allongée, une goupille placée dans l'encoche et fixée au convoyeur (10) se déplaçant dans l'encoche de telle manière que la course de la jambe allongée (55) soit limitée par la longueur de l'encoche allongée.

6. Appareil de support d'une carte à circuits imprimés (15) selon la revendication 1, dans lequel chaque rail de serrage (80) comprend une lame de serrage (85) qui entre en contact avec la partie marginale supérieure (15b) de la carte à circuits imprimés (15).

7. Appareil de support d'une carte à circuits imprimés (15) selon la revendication 1, dans lequel le convoyeur (10) comprend :
une paire de rails de convoyeur (20) allongés longitudinalement, orientés parallèlement l'un à l'autre mais écartés l'un de l'autre ;
une pluralité de poulies (25) montées sur chaque rail de convoyeur (20) ;
un moteur (26) accouplé à au moins une poulie (25) sur la pluralité de poulies (25) ;
une courroie d'entraînement (30) montée sur les poulies (25) de chaque rail de convoyeur (20), de manière à ce que, sous l'effet du mouvement de rotation transmis aux poulies (25) par le moteur (26), les courroies d'entraînement (30) se déplacent dans une direction linéaire.

8. Appareil de support d'une carte à circuits imprimés (15) selon la revendication 1, comprenant en outre un support de rail de serrage (23) au niveau de la station de traitement, le support de rail de serrage (23) possédant une cavité intérieure creuse (60) dimensionnée de manière à recevoir un piston (65), le piston (65) ayant une première extrémité (65a) et une seconde extrémité (65b), la première extrémité (65a) étant dimensionnée de manière à entrer en contact avec une première extrémité (70a) d'un ressort hélicoïdal (70) positionné dans la cavité (60) et la seconde extrémité (65b) du piston (65) étant accouplée au rail de serrage (80), une seconde extrémité (70b) du ressort (70) étant logée dans un collet annulaire (73) formé sur une partie intérieure de la cavité (60), dans lequel, si la première extrémité (65a) du piston (65) est déplacée vers le haut, le ressort (70) est comprimé pour permettre à la seconde extrémité (65a) du piston (65) de s'étendre vers l'extérieur par une ouverture (75) ménagée dans une paroi de la cavité (60) afin de déplacer le rail de serrage (80) vers le haut.

9. Procédé de traitement d'une carte à circuits imprimés (15), comprenant les étapes consistant à :
(i) positionner la carte à circuits imprimés (15) sur un convoyeur (10) substantiellement horizontal et amener la carte à circuits imprimés (15) à une station de traitement ;
(ii) déplacer vers le haut une table d'appui (35), disposée horizontalement au-dessous du convoyeur (10) au niveau de la station de traitement, afin qu'un élément d'appui (40, 41), monté sur la table d'appui (35), entre en contact avec une surface inférieure (15a) de la carte à circuits imprimés (15) afin de dégager la carte à circuits imprimés (15) du convoyeur (10) vers le haut ;
(iii) déplacer vers le haut la carte à circuits imprimés (15) jusqu'à ce que des parties marginales supérieures opposées (15b) de la carte à circuits imprimés (15) entrent en contact avec des lames (85) formées sur une paire de rails de serrage (80) précontraints élastiquement vers le bas, les lames (85) et l'élément d'appui (40, 41) supportant alors la carte à circuits imprimés (15) ; et
(iv) traiter la carte à circuits imprimés (15).
